# EUROPÄISCHE PATENTSCHRIFT

(11) **EP 0 429 791 B1**
(45) Veröffentlichungstag und Bekanntmachung des Hinweises auf die Patenterteilung: **06.09.1995**
(21) Anmeldenummer: 90118270.9
(22) Anmeldetag: 24.09.1990
(51) Int. Cl.: H05H 7/00

(54) **Anordnung zum Abstimmen eines Resonators**
Resonator tuning device
Dispositif pour syntoniser un résonateur

(30) Priorität: 29.11.1989 DE 3939409
(43) Veröffentlichungstag der Anmeldung: 05.06.1991
(73) Patentinhaber: AFT Advanced Ferrite Technology GmbH, 71522 Backnang (DE)
(72) Erfinder: Martin, Siegbert, Dipl.-Ing., D-7150 Backnang (DE); Pivit, Erich, Dr.-Ing., D-7151 Allmersbach i.T. (DE); Lenz, Sigmund, Dipl.-Ing., D-7152 Aspach 1 (DE); Russel, Robert P., Darwestown, MD 20874 (US)

(56) Entgegenhaltungen:
- DE-A- 3 527 189
- DE-A- 3 834 984
- 4th EUROPEAN MICROWAVE CONFERENCE - Montreux 10-13 Sept. 1974 - Conf.Proceedings, pp.31-35 Bahri et al: "Electroning tuning of High Power X-Band Magnetrons with Ferrites"
- WORLD PATENTS INDEX LATEST Section Ch, Week 5085, 23. August 1985, Derwent Publications Ltd., London, GB; Class C, AN 85-315253 & SU-A-1 075 885
- IEEE TRANSACTIONS ON MICROWAVE THEORY AND TECHNIQUES. Bd. 36, Nr. 6, Juni 1988, NEW YORK, US, Seiten 1014 - 1022; UHER ET AL.: "Magnetically tunable rectangular waveguide E-planar integrated circuit filters"
- IEEE TRANSACTIONS ON NUCLEAR SCIENCE. Bd. NS-30, Nr. 4, August 1983, NEW YORK, US, Seiten 2173 - 2175; W.R. SMYTHE: "Reducing ferrite tuner power loss by bias field rotation"

## Beschreibung

Die vorliegende Erfindung betrifft eine Anordnung zum Abstimmen eines Resonators, welche eine an den Hohlraumresonator angekoppelte ferrit-belastete Leitung aufweist und Mittel besitzt, mit denen für das Ferrit ein veränderbares Vormagnetisierungsfeld erzeugt werden kann, das senkrecht zu einem in der Leitung existierenden Hochfrequenz-Magnetfeld orientiert ist.

Derartige Ferrit-Abstimmvorrichtungen für Hohlraumresonatoren von Teilchenbeschleunigern oder Synchrotron-Speicherringen sind z,B. aus "European Particle Acceleration Conference", 3. Vol. 1987, 3. Ref. S. 1543 - 1545 bekannt. Diese Abstimmvorrichtungen sind als Koaxialleitungen ausgeführt, in denen koaxial im Innenleiter ein oder mehrere Ferritringe angeordnet sind. Eine den Außenleiter umgebende Ringspule erzeugt das veränderbare Vormagnetisierungsfeld für das Ferrit. Fertigungstechnisch sind ringförmige Ferrite sehr aufwendig. Außerdem ist die Kühlung dieser Ferritringe sehr schwierig, da der Wärmekontakt nur an deren Außen- bzw. Innenmantel oder durch zwischengelegte Keramikringe (BeO) hoher Wärmeleitfähigkeit vorgenommen werden kann. Aufgrund stark unterschiedlicher Wärmeausdehnungskoeffizienten zwischen Ferrit, Keramik und Metall besteht die Gefahr, daß die Ferritringe zerspringen. Der Abstimmeffekt einer ferritbelasteten Leitung beruht darauf, daß ihre Ausbreitungskonstante von der Permeabilität des Ferrits abhängt. Die Permeabilität des Ferrits läßt sich durch ein Vormagnetisierungsfeld verändern. Wird nun eine solche abstimmbare Leitung an einen Resonator angekoppelt, so kann damit dessen Resonanzfrequenz in gewünschter Weise geändert werden.

Handelt es sich beispielsweise um einen abzustimmenden Hohlraumresonator, wie er bei Teilchenbeschleunigern oder Synchrotron-Speicherringen eingesetzt wird, so verlangt dessen sehr hohe Güte eine äußerst verlustarme Abstimmanordnung. Wie aus der zuvor zitierten Literatur hervorgeht, wird das Ferrit in der Leitung einem Vormagnetisierungsfeld ausgesetzt, das senkrecht zum Hochfrequenz-Magnetfeld in der Leitung orientiert ist. Damit gemäß dem genannten Stand der Technik das gesamte in der Koaxialleitung angeordnete Ferrit nur von einer senkrecht zum HF-Magnetfeld orientierten Komponente des axial zum Koaxialinnenleiter gerichteten Vormagnetisierungsfeldes durchsetzt wird, muß die das Vormagnetisierungsfeld erzeugende Spule erheblich weiter in axialer Richtung der Leitung ausgedehnt sein als das Ferrit. Um also eine verlustarme Abstimmanordnung zu schaffen, muß hier ein recht voluminöser Elektromagnet eingesetzt werden.

Der Erfindung liegt nun die Aufgabe zugrunde, eine Abstimmanordnung der eingangs genannten Art anzugeben, die sehr verlustarm ist und sich mit möglichst geringem fertigungstechnischen Aufwand verwirklichen läßt.

Erfindungsgemäß wird die Aufgabe durch die Merkmale des Anspruchs 1 gelöst. Vorteilhafte Weiterbildungen der Erfindung gehen aus den Unteransprüchen hervor.

Da nach der Erfindung eine Streifenleitung als Abstimmanordnung verwendet wird, ist der fertigungstechnische Aufwand für die Ferritelemente geringer als beim Stand der Technik. Denn es können aufgrund des planen Innen- bzw. Außenleiters ebene Ferritelemente verwendet werden, um damit den Innen- und/oder Außenleiter der Streifenleitung zu belegen.

Auch läßt sich hierbei die in dem Ferrit entstehende Verlustwärme sehr effektiv und auf einfache Weise abführen, indem Kühlkanäle in dem Innen- und/oder Außenleiter vorgesehen werden. Temperaturabhängige Volumenänderungen der Streifenleitung wirken sich nicht störend auf die auf den Innenleiter und/oder an der Innenseite des Außenleiters fixierten planaren Ferritelemente aus. Die Streifenleitung läßt es außerdem zu, eine Vormagnetisierungsvorrichtung zu verwenden, die nur ein geringes Streufeld erzeugt, wodurch eine sehr verlustarme, homogene Magnetisierung des Ferrits möglich ist. Es kann nämlich außer um die Streifenleitung herum mit geringem Aufwand ein magnetischer Rückschluß hergestellt werden. Da die Streifenleitung nur einen relativ geringen Luftspalt für die Vormagnetisierung des Ferrits darstellt, ist der Leistungsbedarf hierfür nicht sehr hoch.

Anhand eines in der Zeichnung dargestellten Ausführungsbeispiels wird nachfolgend die Erfindung näher erläutert. Es zeigen
- Fig. 1: eine perspektivische Darstellung einer ferritbelasteten Streifenleitung,
- Fig. 2: einen Querschnitt durch die Streifenleitung mit einer Vormagnetisierungsvorrichtung und
- Fig. 3: ein Diagramm, daß die Verlustleistung im Ferrit in Anhängigkeit vom Vormagnetisierungsfeld wiedergibt.

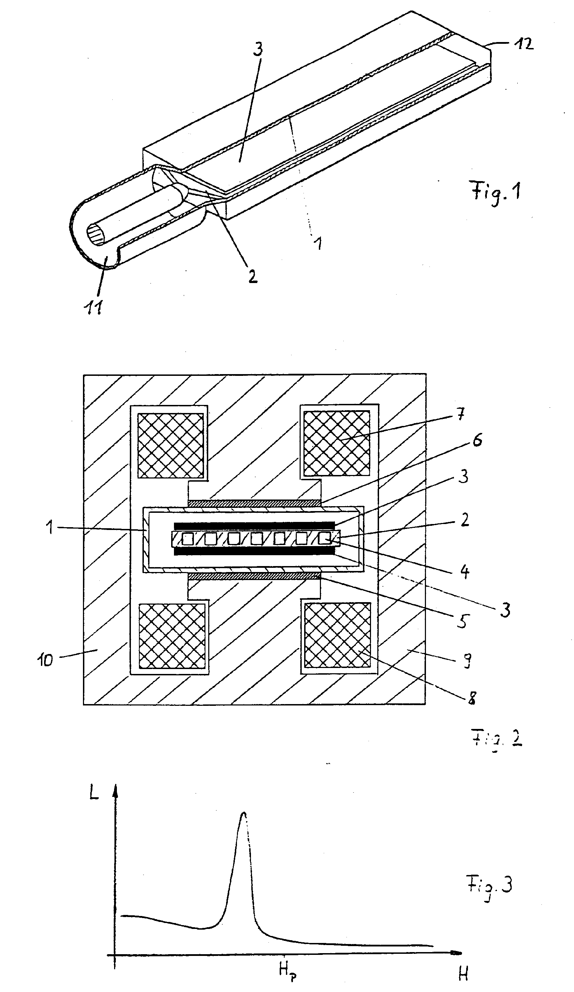

Als Abstimmanordnung beispielsweise für einen Hohlraumresonator eines Teilchenbeschleunigers oder eines Synchrotron-Speicherringes wird eine Streifenleitung verwendet, wie sie die Fig. 1 in teilweise aufgeschnittener perspektivischer Ansicht und die Fig. 2 im Querschnitt zeigt.

Es handelt sich in diesem Ausführungsbeispiel um eine symmetrische Streifenleitung, bestehend aus einem geschlossenen Außenleiter 1 und einem darin verlaufenden planaren Innenleiter 2. Die Streifenleitung ist mit einem stark reflektierenden Abschluß 12 (Z.B. Kurzschluß) versehen. Den Fig. 1 und 2 ist zu entnehmen, daß der Innenleiter 2 der Streifenleitung auf beiden Seiten mit Ferrit 3 belegt ist. Das Ferrit setzt sich z.B. aus mehreren Ferritscheiben zusammen, die auf dem Innenleiter 2 aufgeklebt sind. Es besteht auch die in der Zeichnung nicht dargestellte Möglichkeit, die einander gegenüberliegenden Innenseiten (Breitseiten) des Außenleiters 1 oder sowohl Innen- als auch Außenleiter der Streifenleitung mit Ferrit zu belegen. Die im Ferrit 3 entstehende Verlustwärme kann sehr wirkungsvoll und auf einfache Weise abgeführt werden mit Hilfe von Kühlkanälen 4, welche den Innenleiter 2 und gegebenenfalls auch den Außenleiter 1 durchziehen.

Das in der Streifenleitung, sei es auf dem Innenleiter 2 und/oder am Außenleiter 1, befindliche Ferrit 3 wird einem Vormagnetisierungsfeld ausgesetzt, das senkrecht zu dem in der Streifenleitung sich ausbreitenden Hochfreguenzmagnetfeld orientiert ist. Dazu ist ein Permanentmagnet vorhanden, zwischen dessen zwei Polen 5 und 6 die Streifenleitung so angeordnet ist, daß das zwischen den Polen 5 und 6 vorherrschende Magnetfeld senkrecht auf den mit Ferrit 3 belegten Ebenen des Innenleiters 2 und/oder Außenleiters 1 steht. Dieser Permanentmagnet erzeugt ein so hohes statisches Magnetfeld Hₚ, daß das Ferrit 3 oberhalb seiner gyromagnetischen Resonanz betrieben wird. Die in Fig. 3 dargestellte Abhängigkeit der magnetischen Verlustleistung L im Ferrit in Abhängigkeit vom angelegten Magnetfeld H zeigt, daß die Verlustleistung oberhalb der gyromagnetischen Resonanz mit zunehmendem Magnetfeld abnimmt. In diesem verlustarmen Bereich soll der Betrieb der Abstimmanordnung erfolgen. Ein dem statischen Magnetfeld Hₚ überlagertes veränderbares Magnetfeld erlaubt die Abstimmung der ferrit-belasteten Streifenleitung auf die gewünschte Phase des Eingangsreflexionsfaktors der Leitung. Dieses veränderbare Magnetfeld erzeugt ein Elektromagnet, der gemäß Fig. 2 aus zwei auf die beiden Pole 5 und 6 gewickelten Spulen 7 und 8 besteht. Die Verwendung eines Permanentmagneten und eines Elektromagneten bringt den Vorteil, daß zur Abstimmung der ferritbelasteten Streifenleitung nur kleine Ströme erforderlich sind, da dank des Permantentmagneten nur ein Teil der erforderlichen Magnetisierung vom Elektromagneten aufgebracht werden muß. Vorteilhaft ist auch, daß bei einem eventuellen Ausfall des Steuerstroms für den Elektromagneten die Verlustleistung L im Ferrit nicht sehr stark ansteigt, weil der Permanentmagnet die Magnetisierung des Ferrits immer oberhalb der gyromagnetischen Resonanz hält.

Das Streufeld der dargelegten Vormagnetisierungsanordnung kann dadurch sehr gering gehalten werden, daß - wie die Fig. 2 zeigt - außerhalb der Streifenleitung 1, 2 ein magnetischer Rückschluß von einem Pol 5 zum anderen Pol 6 erfolgt. Der magnetische Rückschluß ist durch zwei symmetrisch angeordnete, sich um beide Schmalseiten der Streifenleitung herum erstreckende Joche 9 und 10 realisiert.

Die vorangehend beschriebene Streifenleitung wird in bekannter Weise, z. B. über eine Koaxialleitung (11) (s. Fig. 1) an den jeweiligen abzustimmenden Hohlraumresonator angekoppelt.

Die Abmessungen der Streifenleitung hängen von dem geforderten Durchstimmbereich ab. Z.B. beträgt die Länge der Leitung ca. 1m, wenn bei einer Betriebsfrequenz von 50 MHz die Phase des Eingangsreflexionsfaktors der Leitung zwischen 0° und 90° durchstimmbar sein soll. Für diesen Fall ist der Innenleiter 170mm breit und 15mm dick, der Außenleiter hat eine innere Breite von 200mm und eine innere Höhe von 60mm, die Wandstärke des Außenleiters an den senkrecht zum Vormagnetisierungsfeld verlaufenden Breitseiten beträgt 3mm und der Ferritbelag auf dem Innenleiter ist 7,5mm dick und 160mm breit. Bei einem Ferrit mit einer Sättigungsmagnetisierung 4πMₛ von etwa 1000 G beträgt die Dämpfung ungefähr 0,04 dB, wenn die Phase des Eingangsreflexionsfaktors auf ca. 90° abgestimmt ist.

Die hier zugrundeliegende Abstimmanordnung kann mit einer Hochfrequenzleistung bis zu 300 kW betrieben werden und sie hat eine Spannungfestigkeit von ca. 15 kV.

## Patentansprüche

1. Anordnung zum Abstimmen eines Resonators, welche eine an den Resonator angekoppelte ferrit-belastete, mit einem reflektierenden Abschluß versehene Leitung aufweist und Mittel besitzt, mit denen für das Ferrit ein veränderbares Vormagetisierungsfeld erzeugt werden kann, das senkrecht zu einem in der Leitung existierenden Hochfrequenz-Magnetfeld orientiert ist, dadurch gekennzeichnet, daß die ferrit-belastete Leitung eine Streifenleitung (1, 2) ist, deren Innen- und/oder Außenleiter mit Ferrit (3) belegt ist.

2. Anordnung nach Anspruch 1, dadurch gekennzeichnet, daß die Mittel zur Vormagnetisierung des Ferrits (3) aus einem Permanentmagneten (5, 6), der ein das Ferrit (3) oberhalb seiner gyromagnetischen Resonanz betreibendes Magnetfeld erzeugt, und einem Elektromagneten (7, 8) bestehen, mit dem ein veränderbares Magnetfeld erzeugt werden kann, das dem statischen Magnetfeld des Permanentmagneten (5, 6) überlagert ist.

3. Anordnung nach Anspruch 1, dadurch gekennzeichnet, daß der mit Ferrit (3) belegte Innen- (2) und/oder Außenleiter (1) der Streifenleitung mit Kühlkanälen (4) versehen ist.

## Claims

1. Arrangement for the tuning of a resonator, which comprises a ferrite-loaded line coupled to the resonator and provided with a reflecting closure and which possesses means able to produce for the ferrite a variable pre-magnetising field which is oriented perpendicularly to a high-frequency magnetic field existing in the line, characterised thereby that the ferrite-loaded line is a strip line (1, 2), the inner and/or outer conductor of which is coated with ferrite (3).

2. Arrangement according to claim 1, characterised thereby that the means for the pre-magnetising of the ferrite (3) consists of a permanent magnet (5, 6), which produces a magnetic field energising the ferrite (3) above its gyromagnetic resonance, and an electromagnet (7, 8), by which a variable magnetic field, which is superimposed on the static magnetic field of the permanent magnet (5, 6), can be produced.

3. Arrangement according to claim 1, characterised thereby that the inner conductor (2) and/or outer conductor (1), coated with ferrite (2), of the strip line is provided with cooling channels (4).

## Revendications

1. Dispositif d'accord d'un résonateur, qui comporte une ligne munie d'une terminaison réfléchissante chargée par ferrite, couplée au résonateur, et possède des moyens grâce auxquels un champ de prémagnétisation variable peut être créé pour la ferrite, qui est orienté perpendiculairement à un champ haute fréquence existant dans la ligne, caractérisé en ce que la ligne chargée par ferrite est une ligne à bande (1, 2), dont le conducteur intérieur et/ou extérieur est garni de ferrite (3).

2. Dispositif selon la revendication 2, caractérisé en ce que les moyens de prémagnétisation de la ferrite (3) se composent d'un aimant permanent (5, 6) qui crée un champ magnétique plaçant la ferrite (3) au-dessus de sa résonance gyromagnétique, et d'un électro-aimant (7, 8), avec lequel peut être créé un champ magnétique variable qui est superposé au champ magnétique statique de l'aimant permanent (5, 6).

3. Dispositif selon la revendication 1, caractérisé en ce que le conducteur intérieur (2) et/ou extérieur (1) garni de ferrite (3) de la ligne à bande est muni de canaux de refroidissement (4).
